# FASCICULE DE BREVET EUROPEEN

(11) **EP 2 291 710 B1**
(45) Date de publication et mention de la délivrance du brevet: **23.03.2016**
(21) Numéro de dépôt: 09772274.8
(22) Date de dépôt: 09.06.2009
(51) Int. Cl.: G02F 1/35, G01N 21/62, G01N 33/00

(54) **DISPOSITIF GENERATEUR D'IMPULSIONS LASER A LARGE BANDE SPECTRALE NOTAMMENT POUR SONDE ATOMIQUE TOMOGRAPHIQUE**
VORRICHTUNG ZUR ERZEUGUNG VON LASERIMPULSEN MIT BREITEM SPEKTRALBAND, IM BESONDEREN FÜR EINE TOMOGRAFISCHE ATOMSONDE
DEVICE FOR GENERATING WIDE SPECTRAL BAND LASER PULSES, PARTICULARLY FOR A TOMOGRAPHIC ATOM PROBE

(30) Priorité: 10.06.2008 FR 0803218
(43) Date de publication de la demande: 09.03.2011
(73) Titulaire: Cameca, 92230 Genneviliiers (FR); Centre National de la Recherche Scientifique, 75016 Paris (FR)
(72) Inventeur: DECONIHOUT, Bernard, F-76000 Rouen (FR); VURPILLOT, François, F-76000 Rouen (FR); VELLA, Angela, F-76000 Rouen (FR)
(74) Mandataire: Lucas, Laurent Jacques
(86) Numéro de dépôt international: PCT/EP2009/057079
(87) Numéro de publication internationale: WO 2010/000574

(56) Documents cités:
- WO-A1-2008/003138
- B. GAULT ET AL: "Ultrafast laser assisted field evaporation and atom probe tomography applications" JOURNAL OF PHYSICS CONFERENCE SERIES, vol. 59, 2007, pages 132-135, XP002565971
- HYUNGSIK LIM ET AL: "Ultrahigh resolution optical coherence tomography with a fiber laser source at 1 mum" OPTICS LETTERS, vol. 30, no. 10, 15 mai 2005 (2005-05-15), pages 1171-1173, XP002565972
- R R ALFANO: "The ultimate white light" SCIENTIFIC AMERICAN (INTERNATIONAL EDITION) SCIENTIFIC AMERICAN USA, vol. 295, no. 6, 1 décembre 2006 (2006-12-01), pages 86-93, XP002511467 stevenage ISSN: 0036-8733
- R R ALFANO: "The supercontinuum gains momentum" LASER FOCUS WORLD, [Online] vol. 41, no. 5, 1 mai 2005 (2005-05-01), XP002511468 PENNWELL, TULSA, OK, US ISSN: 1043-8092 Extrait de l'Internet: URL:http://www.laserfocusworld.com/article s/print.html?id=232485&bPool=LFW.pennnet.c om%2farticle_tool_bar> [extrait le 2009-01-20]
- J. SOLIS ET AL: "Evidence of a nonthermal mechanism for ejection of ions and neutrals during excimer laser ablation of Ge" JOURNAL OF APPLIED PHYSICS USA, vol. 74, no. 6, 15 septembre 1993 (1993-09-15), pages 4271-4273, XP002511469 stevenage ISSN: 0021-8979
- A. VELLA ET AL: "Evidence of field evaporation assisted by nonlinear optical rectification induced by ultrafast laser" PHYSICAL REVIEW B (CONDENSED MATTER AND MATERIALS PHYSICS) APS THROUGH AIP USA, vol. 73, no. 16, 15 avril 2006 (2006-04-15), pages 165416-1, XP002511470 stevenage ISSN: 0163-1829
- T. F KELLY ET AL.: "Atom probe tomography defines mainstream microscopy at the atomic scale." MCROSCOPY TODAY, 1 juillet 2006 (2006-07-01), pages 34-40, XP002511471 largo Fl.

## Description

La présente invention concerne le domaine général de l'analyse de la composition d'échantillons de matériaux. Elle concerne plus particulièrement les dispositifs d'analyse fonctionnant par évaporation d'un échantillon de matériau au moyen d'un laser, en particulier les sondes atomiques tomographiques.

Il est connu que dans un dispositif de type sonde atomique tomographique assistée par laser, une tension continue est appliquée sur l'échantillon de matériau à analyser. Cet échantillon se présente sous la forme d'une pointe usinée, portée à un potentiel électrique donné, dont l'extrémité est illuminée par des impulsions laser focalisées, l'énergie apportée par les impulsions provoquant l'évaporation des atomes constituant le matériau. Suivant un principe connu, une évaporation par effet de champ est ainsi occasionnée par le champ électrique généré par l'interaction de l'impulsion laser avec la pointe. En pratique, l'intensité de l'impulsion laser doit être déterminée de façon à fournir pendant un temps aussi bref que possible, l'énergie juste nécessaire pour évaporer une fraction de couche atomique atome par atome.

Il est connu qu'une énergie trop importante et/ou une durée d'impulsion trop longue ont pour conséquences connues, d'une part d'altérer le spectre de masses obtenu par altération de la résolution (présence de trainées spectrales) et d'autre part, notamment dans le cas ou l'intensité de l'impulsion, est trop importante de conduire à la destruction de l'échantillon par effet à la fois thermique et électrostatique.

Par suite l'homme du métier qui met en oeuvre une sonde atomique laser se trouve affronté au problème délicat consistant à déterminer un niveau d'intensité minimum des impulsions a la fois suffisant pour garantir une évaporation des éléments constituant le matériau de la pointe (et donc l'analyse du matériau) et insuffisant pour entrainer une dégradation inacceptable du spectre de masse et pour entrainer une destruction de l'échantillon.

Cependant, cette valeur optimale d'intensité est difficile à déterminer. En effet, il est connu que cette valeur optimale est fonction de plusieurs paramètres. Elle dépend à la fois de la longueur d'onde des impulsions émises, de la composition du matériau analysé et de la géométrie exacte de la pointe échantillon (rayon de courbure, angle de cône, dimensions et régularité de forme).

Or la composition exacte du matériau analysé n'est par principe pas exactement connue, sans quoi l'analyse du spectre de masse ne serait pas nécessaire. De même, la géométrie exacte de l'échantillon de matériau n'est pas non plus rigoureusement maîtrisée. En outre, la géométrie de l'échantillon varie au cours de l'analyse du fait de la perte de matière occasionnée par l'évaporation.

Par conséquent, en l'état de l'art actuel comme décrit dans "Ultrafast laser assisted field evaporation and atom probe tomography applications" de B.Gault et al, Journal of physics: Conference series 59 (2007) pages 132-135, l'obtention d'impulsions laser ayant l'intensité optimale, relève du réglage empirique et l'homme du métier est généralement contraint, compte tenu de la source laser employée, de procéder par tâtonnement au réglage de l'intensité des impulsions laser. En outre, pour effectuer l'analyse de différents échantillons de matériaux, il est généralement contraint de réaliser un réglage spécifique pour chaque échantillon analysé, même dans le cas où les échantillons analysés sont réalisés dans un même matériau. De plus, du fait que la géométrie de l'échantillon varie au cours de l'analyse, l'homme du métier est généralement également contraint de modifier le réglage d'intensité en cours d'analyse pour préserver la qualité des spectres de masses.

De la sorte, pour l'homme du métier, procéder à la réalisation d'analyses répétitives permettant par exemple de contrôler qu'un procédé de réalisation d'un matériau composite fournit bien un matériau de composition constante, s'avère être une opération difficile et fastidieuse qui conduit parfois à la destruction de certains échantillons et qui entraine leur remplacement.

Un but de l'invention est de proposer une solution permettant de résoudre les problèmes évoqués précédemment, autrement dit de proposer une solution pour produire, dans le cadre d'une sonde atomique laser, des impulsions lumineuses dont l'intensité est suffisante pour assurer l'évaporation, couche atomique après couche atomique, des éléments constituant l'échantillon, et cependant insuffisante pour conduire à la destruction de l'échantillon en cours d'analyse ou pour conduire à l'obtention d'un spectre de masse de résolution inacceptable.

A cet effet, l'invention a pour objet un dispositif générateur d'impulsions laser large bande spectrale pour réaliser l'émission d'impulsions lumineuses dont le spectre est constitué de longueurs d'ondes particulières, générateur d'impulsions laser qui comporte :
- une source lumineuse laser monochromatique dont l'intensité est réglable ;
- des moyens optiques non linéaires pour réaliser un élargissement spectral de l'onde émise par la source lumineuse ;
la source lumineuse et les moyens optiques non linéaires étant configurés et agencé de façon à créer un supercontinuum blanc dont le spectre continu contient les longueurs d'ondes particulières. Les documents "Ultra-resolution optical coherence tomography with a fiber laser source at 1µm de Hyungsik-Lim et al, optics letters vol. 30, no.10, 15-5-2005, et WO 2008/003138 décrivent une source de super continuum blanc utilisée pour l'optical coherence tomography.

Selon un mode de réalisation de l'invention, les moyens optiques non linéaires sont constitués par un élément de cristal photonique.

Selon une variante de réalisation de l'invention, l'élément de cristal photonique est composé d'oxyde de silicium.

Selon une autre variante de réalisation de l'invention, l'élément de cristal photonique est composé d'oxyde d'aluminium.

Selon un autre mode de réalisation de l'invention, les moyens optiques non linéaires sont constitués par une fibre optique microstructurée.

L'invention a également pour objet une sonde atomique tomographique pour analyser un échantillon de matériau placé dans une chambre d'analyse et comportant des moyens pour générer des impulsions lumineuses destinées à produire l'évaporation de l'échantillon de matériau à analyser et des moyens pour guider ces impulsions sur l'échantillon, les moyens pour générer les impulsions lumineuses étant constitués par le dispositif générateur d'impulsions laser large bande selon l'invention.

Selon l'invention, l'évaporation de l'échantillon se produisant par effet de champ optique non linéaire pour une longueur d'onde de résonnance qui varie en cours d'analyse, le dispositif générateur d'impulsions laser large bande de la sonde atomique tomographique est configuré pour produire un supercontinuum blanc apte à couvrir l'ensemble de valeurs prises par la longueur d'onde de résonance au cours de l'analyse.

Selon l'invention encore, la source lumineuse du dispositif générateur d'impulsions laser large bande est configuré pour que l'intensité des impulsions lumineuse générées soit telle que l'évaporation de l'échantillon soit causée seulement par effet de champ optique non linéaire à la longueur d'onde de résonnance.

Le générateur d'impulsions lumineuses selon l'invention permet avantageusement de réaliser pour chaque impulsion laser une évaporation ponctuelle de l'échantillon de matériau analysé, ce qui permet d'obtenir un spectre de masses de bonne résolution. Il permet également d'éviter la destruction d'un échantillon de matériau en cours d'analyse. Il permet également à partir d'un même réglage de l'intensité de la source lumineuse de réaliser l'analyse de plusieurs échantillons d'un même matériau, identiques aux tolérances de fabrication près. Il permet encore de délivrer la longueur d'onde la mieux adaptée à un échantillon, quelle que soit sa forme ou sa nature. Il permet enfin, dans le cas d'un changement de phase en cours d'analyse, d'éviter à avoir à changer la couleur du laser pour assurer l'évaporation et limiter les effets de dégradation du spectre de masses.

Les caractéristiques et avantages de l'invention seront mieux appréciés grâce à la description qui suit, description qui s'appuie sur les figures annexées 1 et 2 qui présentent :
- la figure 1, le synoptique schématique d'un premier exemple de mise en oeuvre du dispositif selon l'invention dans une sonde atomique laser ;
- la figure 2, le synoptique schématique d'un second exemple de mise en oeuvre du dispositif selon l'invention dans une sonde atomique laser.

Pour comprendre les avantages apportés par le dispositif selon l'invention, il faut considérer le principe de fonctionnement d'une sonde atomique tomographique. On rappelle à cet effet que la sonde atomique tomographique est un spectromètre de masse à temps de vol, bien connu de l'homme du métier, permettant d'analyser un échantillon atome par atome. Les données recueillies permettent de représenter le volume de l'échantillon détruit à l'échelle de la maille atomique, ainsi que la nature chimique de chaque atome. Cet échantillon est généralement une fine pointe d'un matériau qui peut être conducteur, isolant ou semi-conducteur. On rappelle également que la résolution en masse d'une sonde atomique assistée par impulsion laser femtoseconde (fs), c'est-à-dire une sonde dans laquelle les éléments constituant l'échantillon sont évaporés au moyen d'impulsions lumineuses dont la durée est de l'ordre de quelques femtosecondes, dépend de la durée pendant laquelle des ions sont émis consécutivement à l'émission d'une impulsion.

Les expériences menées par la déposante montrent que cette durée dépend elle-même du mécanisme physique réellement mis en jeu dans l'évaporation. On peut ainsi distinguer un mécanisme d'évaporation lent (c'est-à-dire supérieur à quelques nanosecondes) par effet thermique et un mécanisme ultrarapide d'évaporation par effet de champ optique non linéaire (de l'ordre de la picoseconde), ce dernier mécanisme produisant avantageusement un effet d'arrachement quasi instantané, athermique, des éléments de l'échantillon. Le mécanisme d'évaporation thermique lent est quant à lui principalement responsable de la limitation de la résolution en masse d'une sonde atomique.

Ces expériences montrent de plus que, pour un échantillon de matériau donné, l'effet rapide d'évaporation se produit préférentiellement pour une longueur d'onde spécifique qui dépend du matériau analysé. Elles montrent également que pour cette longueur d'onde particulière, appelée ici longueur d'onde d'accord, l'intensité de l'impulsion optique nécessaire pour provoquer l'évaporation rapide est sensiblement plus faible que pour les autres longueurs d'ondes de sorte que l'effet thermique lent évoqué précédemment se trouve sensiblement atténué. Elles montrent, en outre, que pour un même matériau analysé, cette longueur d'onde dépend sensiblement de la forme, et des dimensions exactes de cet échantillon.

On constate ainsi que pour deux échantillons d'un même matériau, identiques aux incertitudes de réalisation près, cette longueur d'onde peut être sensiblement différente, de sorte que d'un échantillon à l'autre l'influence de l'évaporation par effet thermique lent peut varier de manière significative.

On constate encore que pour un même échantillon analysé, un échantillon en forme de pointe ou de cône effilé par exemple, cette longueur d'onde peut varier sensiblement au cours de l'analyse de l'échantillon, du fait même que le rayon de courbure (ou l'angle de cône) de l'échantillon analysé varie de façon sensible à mesure que l'évaporation des éléments se produit. On assiste alors, au cours de l'analyse, à une variation significative de l'influence de l'évaporation par effet thermique lent.

On constate en outre, que pour un échantillon de matériau composite formé de différents éléments, un alliage par exemple, cette longueur d'onde peut varier suivant la couche atomique évaporée. Là encore, on assiste alors, au cours de l'analyse, à une variation significative de l'influence de l'évaporation par effet thermique lent.

Les expériences menées par la déposante montrent donc, en résumé, que l'utilisation d'impulsions laser de longueur d'onde fixe, même si la durée des impulsions est de l'ordre de quelques centaines de femtosecondes, et même si la longueur d'onde n'est pas choisie au hasard, peut toutefois conduire à l'apparition d'un effet thermique important.

Si l'on considère les constatations précédentes, on constate que la résolution du problème général rencontré par l'homme du métier qui souhaite réaliser des analyses d'échantillons de matériaux au moyen d'une sonde tomographique avec une résolution en masse satisfaisante, ne consiste plus à trouver un moyen d'ajuster en dynamique l'intensité des impulsions émises par la source lumineuse, mais consiste plutôt, selon l'invention, à proposer un moyen pour illuminer l'échantillon avec des impulsions dont la longueur d'onde correspondant à chaque instant d'illumination à la longueur d'onde d'accord définie précédemment.

Par suite, la solution proposée consiste à remplacer la source lumineuse à longueur d'onde fixe utilisée pour générer les impulsions lumineuses destiner à illuminer l'échantillon dans un équipement de type sonde atomique tomographique par un dispositif générateur d'impulsions lumineuses large bande selon l'invention comportant les éléments suivants :
- une source lumineuse monochromatique d'intensité variable ;
- des moyens optiques non linéaires pour réaliser un élargissement spectral de l'onde émise par la source lumineuse.

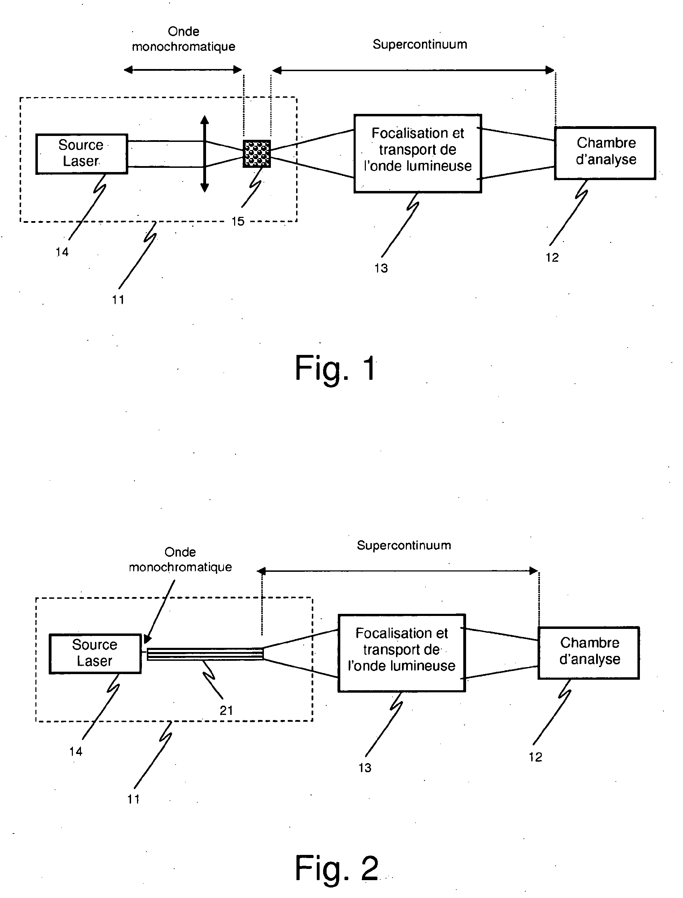

Les figures 1 et 2 illustrent deux modes de réalisation possibles du dispositif selon l'invention au travers de la représentation fonctionnelle schématique d'une sonde atomique tomographique qui figure d'une part les moyens 11 selon l'invention, permettant de produire les impulsions lumineuses large bande destinées à provoquer la vaporisation de l'échantillon, d'autre part des moyens de guidage et de focalisation 13 et d'autre part encore la partie fonctionnelle de la sonde, la chambre d'analyse 12, dans laquelle l'échantillon est positionné.

Selon l'invention, la source lumineuse 14 et les moyens optiques non linéaires 15 ou 21 sont agencés de façon à produire un supercontinuum.

On rappelle ici que la formation d'un supercontiuum est un phénomène d'optique non-linéaire qui correspond à un élargissement de spectre très prononcé à partir d'une onde électromagnétique. Le supercontinuum est ici consécutif au passage de l'onde lumineuse monochromatique produite par la source lumineuse au travers des moyens optiques non linéaires. Les effets non-linéaires élargissent le spectre du faisceau de départ au cours de sa traversée du matériau.

Selon l'invention, les moyens optiques non linéaires 15 ou 21, utilisés sont choisis et configurés de façon à ce que l'élargissement spectral soit suffisant pour couvrir l'ensemble des longueurs d'ondes de résonnance utiles et que le spectre obtenu soit un spectre avantageusement continu. On réalise ainsi ce qu'il est convenu d'appeler un supercontinuum blanc.

Les impulsions lumineuses large bande ainsi produites sont transportées au voisinage de l'échantillon, de manière classique, par des moyens de guidage et de focalisation 13. Cependant, la bande passante des moyens utilisés est ici adaptée à l'encombrement spectral de l'impulsion lumineuse large bande ainsi produite.

Les moyens optiques non linéaires 15. ou 21 destinés à élargir le spectre de l'onde émise par la source 14 peuvent consister en différents moyens connus. II est, par exemple, possible d'utiliser une fibre optique microstructurée fortement non linéaires 21 comme l'illustre la figure 2, ou encore plus simplement un élément de cristal photonique, de dioxyde de silicium (SiO₂) ou d'oxyde d'aluminium (Al₂O₃) par exemple, à l'intérieur duquel on focalise l'onde lumineuse produite par la source 14, comme l'illustre la figure 1. Dans ces deux cas, ces moyens connus sont ici dimensionnés de façon à admettre la puissance émise par la source lumineuse 14.

Le dispositif selon l'invention permet avantageusement de produire de manière simple des impulsions lumineuses dont le spectre couvre la totalité des longueurs d'ondes de résonnance permettant une évaporation des atomes constituant l'échantillon l'évaporation par effet de champ des atomes d'un échantillon et de limiter ainsi l'évaporation par effet thermique.

Du fait de cette large couverture spectrale, il permet en outre avantageusement, simplement en limiter la puissance de la source lumineuse, de produire des impulsions dont l'intensité est juste suffisante pour que selle la composante spectrale dont la longueur d'onde correspond à la longueur d'onde de résonnance du matériau à l'instant considéré agisse sur l'échantillon et produise son évaporation. Ainsi, quelle que soit sa géométrie exacte à l'instant d'émission d'une l'impulsion lumineuse l'échantillon se trouve naturellement exposé à la longueur d'onde de résonance correspondante, qui favorise l'apparition de l'effet ultrarapide (et athermique) d'évaporation par effet de champ optique non linéaire. On limite en outre les risques de destruction de l'échantillon.

## Revendications

1. Sonde atomique tomographique pour analyser un échantillon de matériau placé dans une chambre d'analyse (12) et comportant des moyens (15, 21) pour générer des impulsions lumineuses propre à produire une évaporation contrôlée, couche atomique par couche atomique, d'un échantillon de matériau à analyser et des moyens 13 pour guider ces impulsions sur l'échantillon, comportant une source lumineuse laser monochromatique (14) dont l'intensité est réglable, **caractérisée en ce que** lesdits moyens (14, 15, 21) pour générer lesdites impulsions lumineuses sont constitués d'un dispositif générateur d'impulsions laser à large bande spectrale comportant :
- des moyens optiques non linéaires (15, 21) pour réaliser un élargissement spectral de l'onde émise par la source lumineuse(14) ; la source lumineuse (14) et les moyens optiques non linéaires (15, 21) étant configurés et agencés de façon à créer un supercontinuum blanc dont le spectre continu couvre l'ensemble des longueurs d'ondes nécessaires à une évaporation rapide, par effet de champ optique non linéaire, de l'échantillon;
l'intensité de la source lumineuse (14) étant réglée de telle façon que l'évaporation de l'échantillon par effet thermique au cours de l'analyse soit minimale.

2. Sonde atomique tomographique selon la revendication 1, **caractérisée en ce que** la source lumineuse (14) du dispositif générateur d'impulsions laser large bande est configuré pour que l'intensité des impulsions lumineuse générées soit telle que l'évaporation de l'échantillon soit causée seulement par effet de champ optique non linéaire à la longueur d'onde de résonnance.

3. Dispositif selon l'une quelconque des revendications 1 à 2, **caractérisé en ce que** les moyens optiques non linéaires (15) sont constitués par un élément de cristal photonique.

4. Dispositif selon la revendication 3, **caractérisé en ce que** l'élément de cristal photonique est composé d'oxyde de silicium.

5. Dispositif selon la revendication 3, **caractérisé en ce que** l'élément de cristal photonique est composé d'oxyde d'aluminium.

6. Dispositif selon l'une quelconque des revendications 1 à 2, **caractérisé en ce que** les moyens optiques non linéaires (21) sont constitués par une fibre optique microstructurée.

## Patentansprüche

1. Tomografische Atomsonde zum Analysieren einer in einer Analysekammer (12) platzierten Materialprobe, mit Mitteln (15, 21) zum Erzeugen von Lichtimpulsen, die eine kontrollierte Verdampfung, Atomschicht für Atomschicht, einer zu analysierenden Materialprobe erzielen können, und Mitteln (13) zum Leiten dieser Impulse auf die Probe, umfassend eine monochromatische Laserlichtquelle (14), deren Intensität geregelt werden kann, **dadurch gekennzeichnet, dass** die Mittel (14, 15, 21) zum Erzeugen der Lichtimpulse von einem Laserimpulsgenerator mit großem Spektralband gebildet werden, der Folgendes umfasst:
- nichtlineare optische Mittel (15, 21) zum Erzielen einer Spektralvergrößerung der von der Lichtquelle (14) ausgesendeten Welle; wobei die Lichtquelle (14) und die nichtlinearen optischen Mittel (15, 21) so konfiguriert und ausgestaltet sind, dass sie ein weißes Superkontinuum erzeugen, dessen kontinuierliches Spektrum den für eine rasche Verdampfung notwendigen Satz von Wellenlängen, durch nichtlinearen optischen Feldeffekt, der Probe bedecken;
wobei die Intensität der Lichtquelle (14) so geregelt wird, dass die Verdampfung der Probe durch Wärmeeffekt im Laufe der Analyse minimal ist.

2. Tomografische Atomsonde nach Anspruch 1, **dadurch gekennzeichnet, dass** die Lichtquelle (14) des Laserimpulsgenerators mit großem Band so konfiguriert ist, dass die Intensität der erzeugten Lichtimpulse so ist, dass eine Verdampfung der Probe nur durch nichtlinearen optischen Feldeffekt auf der Resonanzwellenlänge erzeugt wird.

3. Vorrichtung nach einem der Ansprüche 1 bis 2, **dadurch gekennzeichnet, dass** die nichtlinearen optischen Mittel (15) durch ein Photonenkristallelement gebildet werden.

4. Vorrichtung nach Anspruch 3, **dadurch gekennzeichnet, dass** das Photonenkristallelement aus Siliciumoxid zusammengesetzt ist.

5. Vorrichtung nach Anspruch 3, **dadurch gekennzeichnet, dass** das Photonenkristallelement aus Aluminiumoxid zusammengesetzt ist.

6. Vorrichtung nach einem der Ansprüche 1 bis 2, **dadurch gekennzeichnet, dass** die nichtlinearen optischen Mittel (21) von einer mikrostrukturierten Faser gebildet werden.

## Claims

1. A tomographic atom probe for analyzing a material specimen placed in an analysis chamber (12) and comprising means (15, 21) for generating light pulses suitable for producing a controlled evaporation, atomic layer by atomic layer, of a material specimen to be analyzed and means 13 for guiding these pulses onto the specimen, comprising a monochromatic laser light source (14) whose intensity is adjustable, **characterized in that** said means (14, 15, 21) for generating said light pulses consist of a wide spectral band laser pulse generating device comprising:
- non-linear optical means (15, 21) for carrying out spectral widening of the wave emitted by the light source (14);
the light source (14) and the non-linear optical means (15, 21) being configured and arranged so as to create a white supercontinuum whose continuous spectrum covers the set of wavelengths necessary for a fast evaporation, by non-linear optical field effect, of the specimen and ;
the intensity of the light source (14) being adjusted in such a way that the evaporation of the specimen by thermal effect in the course of the analysis is minimal.

2. The tomographic atom probe as claimed in claim 1, **characterized in that** the light source (14) of the wide band laser pulse generating device is configured so that the intensity of the light pulses generated is such that the evaporation of the specimen is caused only by non-linear optical field effect at the resonance wavelength.

3. The device as claimed in any one of claims 1 to 2, **characterized in that** the non-linear optical means (15) consist of a photonic crystal element.

4. The device as claimed in claim 3, **characterized in that** the photonic crystal element is composed of silicon oxide.

5. The device as claimed in claim 3, **characterized in that** the photonic crystal element is composed of aluminum oxide.

6. The device as claimed in any one of claims 1 to 2, **characterized in that** the non-linear optical means (21) consist of a microstructured optical fiber.
